# EUROPÄISCHE PATENTSCHRIFT

(11) **EP 2 321 220 B1**
(45) Veröffentlichungstag und Bekanntmachung des Hinweises auf die Patenterteilung: **20.04.2016**
(21) Anmeldenummer: 09771469.5
(22) Anmeldetag: 29.07.2009
(51) Int. Cl.: C01B 33/037, C01B 33/02, C30B 11/00, C30B 15/00, C30B 15/34, C30B 29/06

(54) **VERFAHREN ZUM ENTFERNEN VON NICHTMETALLISCHEN VERUNREINIGUNGEN AUS METALLURGISCHEM SILICIUM**
PROCESS FOR REMOVING NONMETALLIC IMPURITIES FROM METALLURGICAL SILICON
PROCÉDÉ D'ÉLIMINATION D'IMPURETÉS NON MÉTALLIQUES DE SILICIUM MÉTALLURGIQUE

(30) Priorität: 01.08.2008 DE 102008036143
(43) Veröffentlichungstag der Anmeldung: 18.05.2011
(73) Patentinhaber: Berlinsolar GmbH, 12489 Berlin (DE); Spawnt Private S.à.r.l., 1148 Luxembourg (LU)
(72) Erfinder: MOHSSENI-ALA, Seyed-Javad, 06766 Bitterfeld-Wolfen (DE); LIPPOLD, Gerd, 04179 Leipzig (DE); DELTSCHEW, Rumen, 04319 Leipzig (DE); BAUCH, Christian, 06766 Bitterfeld-Wolfen (DE); KIRSCHT, Fritz, 12621 Berlin (DE); GEBEL, Thoral, 01465 Dresden (DE); OUNADJELA, Kamel, Belamont, CA 94002 (US); HEUER, Matthias, 12555 Berlin (DE)
(74) Vertreter: Epping - Hermann - Fischer
(86) Internationale Anmeldenummer: PCT/DE2009/001059
(87) Internationale Veröffentlichungsnummer: WO 2010/012273

(56) Entgegenhaltungen:
- EP-A1- 0 304 714
- WO-A2-2007/127482
- WO-A2-2009/143825

## Beschreibung

Die vorliegende Erfindung betrifft ein Verfahren zum Entfernen von nichtmetallischen Verunreinigungen aus metallurgischem Silicium.

Mit der hier verwendeten Bezeichnung "metallurgisches Silicium" sollen sämtliche Si-Qualitätsstufen abgedeckt werden, d.h. metallurgisches Silicium, UMG-Silicium (upgraded metallurgical-grade), Solar-grade-Silicium und Electronicgrade-Silicium, sowie das zugehörige Roh-Silicium und die zugehörigen Vorprodukte der Si-Qualitätsstufen und des entsprechenden Roh-Siliciums. Der Begriff "metallurgisches Silicium" ist daher im weitesten Sinne zu interpretieren.

Metallurgisches Silicium wird mittels unterschiedlicher Technologien gereinigt, um Roh-Silicium zu gewinnen, das sich für die Herstellung von Solarzellen eignet. Derartig behandeltes metallurgisches Silicicum wird als UMG-Silicium (UMG: upgraded metallurgical-grade) bezeichnet. UMG Roh-Silicium besitzt oft noch relativ hohe Konzentrationen an Verunreinigungen, die unerwünscht sind und entfernt werden müssen, um qualitativ hochwertige Solarzellen herstellen zu können. In der deutschen Patentanmeldung 10 2008 025 263.8 ist ein Verfahren zum Aufreinigen von metallurgischem Silicium beschrieben, bei dem metallurgischem Silicium halogenidhaltiges Silicium zugesetzt, aus den Substanzen eine Schmelze hergestellt und die Verunreinigungen aus der Schmelze aussublimiert und in der Form von Metallhalogeniden entfernt werden. Dieses Verfahren betrifft daher die Entfernung von Metallen aus dem metallurgischen Silicium. Das Verfahren eignet sich auch zur weiteren Reinigung von UMG Roh-Silicium. Entfernte Metalle schließen Halbmetalle, Erdalkalimetalle etc. ein. Es hat sich auch gezeigt, dass sich mit diesem Verfahren sehr gute Ergebnisse an Vorprodukten von UMG Roh-Silicium erzielen lassen. Derartige Vorprodukte werden im Folgenden ebenfalls als UMG Roh-Silicium bezeichnet.

In Bezug auf die Entfernung von nichtmetallischen Verunreinigungen aus Silicium ist beispielsweise aus der US 4 312 849 ein Verfahren zum Entfernen von Phosphorverunreinigungen bekannt. Hierbei wird eine Siliciumschmelze hergestellt, durch die ein Gas geblasen wird, das eine Chlorquelle enthält.

Bei einem anderen bekannten Verfahren zum Entfernen von Phosphor aus einer Siliciumschmelze wird eine Vakuumbehandlung der Schmelze durchgeführt. Noch ein anderes bekanntes Verfahren betrifft die gleichzeitige Entfernung von Bor und Phosphor durch einen Plasmareinigungsprozess.

Es ist somit bereits bekannt, nichtmetallische Verunreinigungen aus metallurgischem Silicium mit Hilfe von gasförmigen Chlorquellen zu entfernen. Dabei werden Chlorgas oder Chlor enthaltende Gasgemische in die Si-Schmelze eingeleitet. Die Umsetzung einer derartigen Technologie ist jedoch sehr komplex, da die Einleitung des Chlors direkt in die Schmelze erfolgen muss, was in der Regel durch Röhrchen oder spezielle Düsen geschieht. Eine homogene Verteilung des Chlors über die gesamte Schmelze ist damit nur bedingt möglich. Zudem kann durch die Vorrichtungen zur Einleitung des Chlors in die Schmelze die Schmelze selbst beeinträchtigt werden, d.h. es kann beispielsweise zu Verunreinigungen kommen, die aus den Vorrichtungen zur Gaseinleitung herrühren.

In der Druckschrift EP 0 304 714 A1 wird ein Verfahren zum Entfernen von Verunreinigungen aus Silicium beschrieben. Dabei wird eine Schmelze von Silicium über ein siliciumresistentes Material geleitet, wobei die Verunreinigungen als Film oder als Schlacke auf diesem Material abgeschieden werden. Das siliciumresistente Material ist z.B. als Rohr geformt und kann aus Graphit, Quarz oder Siliciumcarbid bestehen. Das Verfahren kann unter einer Inertgasatmosphäre oder auch in der Gegenwart von reaktiven Gasen wie SiCl₄ durchgeführt werden.

Die Druckschrift WO 2007/127482 A2 beschreibt ein Verfahren zur Aufreinigung von Silicium oder Metallen, wobei das zu reinigende Material mit einem Metallhalogenid gemischt und erwärmt wird. Dabei wird das zu reinigende Material mit dem Metallhalogenid extrahiert. Beim Abkühlen des Gemisches erfolgt eine Phasentrennung, bei der sich eine Metallhalogenidphase vom gereinigten Material abscheidet und dann mechanisch abgetrennt wird. Als Metallhalogenide werden Alkali- oder Erdalkalimetalle verwendet; andere Metallhalogenide werden nicht erwähnt. Des Weiteren muss das Metallhalogenid einen Schmelzpunkt unterhalb des Schmelzpunkts von Silicium aufweisen, sodass eine separate Phase nach dem Abkühlen ausgebildet werden kann.

Der vorliegenden Erfindung liegt die Aufgabe zugrunde, ein Verfahren zum Entfernen von nichtmetallischen Verunreinigungen aus metallurgischem Silicium zu schaffen, das auf besonders einfache und effektive Weise durchführbar ist.

Diese Aufgabe wird erfindungsgemäß bei einer ersten Variante durch ein Verfahren zum Entfernen von nichtmetallischen Verunreinigungen aus metallurgischem Silicium gelöst, das die folgenden Schritte aufweist:
Vermischen von festem halogenidhaltigem Silicium mit dem zu reinigenden metallurgischen Silicium;

Schmelzen der Mischung und dadurch Aussublimieren der Verunreinigungen und Entfernen derselben aus der Schmelze in der Form von Nichtmetallhalogeniden.

Die vorstehend genannte Aufgabe wird bei einer zweiten Variante der Erfindung durch ein Verfahren zum Entfernen von nichtmetallischen Verunreinigungen aus metallurgischem Silicium gelöst, das die folgenden Schritte umfasst:
Aufschmelzen des zu reinigenden metallurgischen Siliciums;
Einführen von festem halogenidhaltigem Silicium in die Schmelze und dadurch Aussublimieren der nichtmetallischen Verunreinigungen und Entfernen derselben aus der Schmelze in der Form von Nichtmetallhalogeniden.

Bei dem erfindungsgemäßen Verfahren findet somit keine gasförmige Chlorquelle zum Entfernen der nichtmetallischen Verunreinigungen Verwendung, wie dies beim Stand der Technik der Fall ist, sondern es wird festes halogenidhaltiges Silicium eingesetzt. Bei dem erfindungsgemäß eingesetzten halogenidhaltigen Silicium handelt es sich vorzugsweise um EG-Silicium (EG: electronic-grade). Das feste halogenidhaltige Silicium wird bei der ersten Variante des erfindungsgemäßen Verfahrens mit dem zu reinigenden metallurgischen Silicium vermischt, wonach eine Schmelze hergestellt wird. Bei der zweiten Variante wird das halogenidhaltige Silicium direkt in eine Schmelze aus dem zu reinigenden metallurgischen Silicium eingeführt.

Überraschenderweise wurde festgestellt, dass mit dem erfindungsgemäß eingesetzten halogenidhaltigen Silicium auch sehr gute Reinigungsergebnisse in Bezug auf nichtmetallische Verunreinigungen erzielt werden können. Dies betrifft insbesondere die Entfernung von Dotierungsmitteln, so dass das erfindungsgemäße Verfahren besonders bevorzugt zum Entfernen von Bor und/oder Phosphor eingesetzt wird. Durch das erfindungsgemäße Verfahren wird daher eine besonders einfache und effiziente Steuerung des Bor- und/oder Phosphor-Gehaltes von metallurgischem Silicium ermöglicht, so dass auf diese Weise das erfindungsgemäße Verfahren besonders bevorzugt zum Steuern und/oder Einstellen des spezifischen Widerstandes von metallurgischem Silicium eingesetzt werden kann. Der spezifische Widerstand ist in Bezug auf eine gesteuerte hohe Solarzelleneffizienz von besonders großer Bedeutung.

Bei dem erfindungsgemäßen Verfahren werden durch das Aufschmelzen des zugesetzten halogenhaltigen Siliciums halogenhaltige Verbindungen freigesetzt und auf homogene Weise in der Schmelze verteilt. Durch die halogenhaltigen Verbindungen werden die nichtmetallischen Verunreinigungen in flüchtige Verbindungen (Nichtmetallhalogenide) überführt, die aus der Schmelze austreten, so dass auf diese Weise der gewünschte Reinigungseffekt erreicht wird.

Bei einer weiteren Variante des erfindungsgemäßen Verfahrens wird die Schmelze mit halogenidhaltigem Silicium nachgefüttert. Mit "Schmelze" ist hierbei die aus dem Gemisch aus halogenidhaltigem Silicium und zu reinigendem Silicium bestehende Schmelze oder die allein aus zu reinigendem Silicium bestehende Schmelze gemeint. In beiden Fällen kann durch das vorgenommene "Nachfüttern" der entsprechende Reinigungsprozess eingestellt werden, beispielsweise nachreguliert werden oder erneut begonnen werden.

Noch eine weitere Ausführungsform des erfindungsgemäßen Verfahrens zeichnet sich dadurch aus, dass die Schmelze homogenisiert wird. Dies kann beispielsweise über eine Agitation der Schmelze erfolgen, insbesondere durch Tiegelrotation, Einsatz eines Rührwerkes etc. Die Schmelze kann jedoch auch allein dadurch homogenisiert werden, dass sie über eine ausreichende Zeit stehengelassen wird, so dass sich hierbei durch Konvektion eine geeignete Homogenisierung ergibt.

Als halogenidhaltiges Silicium wird vorzugsweise chloridhaltiges Silicium verwendet.

Als halogenidhaltiges Silicium kann vorzugsweise ein solches verwendet werden, das im Gemisch mit Si-Anteilen Halogensilan-Anteile enthält. Derartige Halogensilane (SiₙX₂ₙ₊₂, wobei X Halogen und n 1-10, vorzugsweise 1-3, bedeuten) sind vorzugsweise in den Leerräumen von chlorhaltigen Siliciumkörnern vorhanden (physikalisch), können aber durch chemische Bindungen fest an Siliciumatome (Si-X) gebunden sein.

Der entsprechende Halogenidgehalt kann durch Titration mit Silbernitrat (nach Mohr) quantitativ bestimmt werden. IRspektroskopische Messungen (ATR-Technik, Diamant Einfachreflexion) an chlorhaltigem Silicium zeigen ein Signal bei 1.029 cm⁻¹. Die Stärke ist abhängig vom Halogenidgehalt und nimmt bei steigendem Halogenidgehalt zu.

Das halogenidhaltige Silicium findet vorzugsweise mit einem Halogenidgehalt von 1 at% bis 50 at% Verwendung.

Um eine gute Vermischung des halogenidhaltigen Siliciums mit dem aufzureinigenden metallurgischen Silicium zu erreichen, findet vorzugsweise granuläres, insbesondere feinkörniges, halogenhaltiges Silicium Verwendung. Die Korngröße beträgt dabei zweckmäßigerweise 50 µm bis 20.000 µm. Das halogenidhaltige Silicium besitzt vorzugsweise eine Schüttdichte von 0,2 g/cm³ bis 1,5 g/cm³.

Der Halogenidgehalt ist von der Korngröße abhängig. Mit wachsender Korngröße steigt der Halogenidgehalt.

Es hat sich gezeigt, dass mit dem erfindungsgemäßen Verfahren ohne aufwendige Einrichtungen zum Einleiten von Gas in die Schmelze gute Ergebnisse in Bezug auf die Aufreinigung von metallurgischem Silicium erzielt werden können. Durch dieses Verfahren konnten nichtmetallische Verunreinigungen, insbesondere Bor und/oder Phosphor, insbesondere in der Form von Chloriden einwandfrei aus der Schmelze entfernt werden.

Das erfindungsgemäße Aufreinigungsverfahren kann insbesondere bei Si-Kristallisationsverfahren unter Verwendung von UMG Roh-Si eingesetzt werden, beispielsweise bei Blockgussverfahren oder Bridgman-Verfahren, Czochralsky-Verfahren, EFG-Verfahren, String-Ribbon-Verfahren, RSG-Verfahren. Das erfindungsgemäße Verfahren wird dabei zum Aufreinigen der Si-Schmelze verwendet, aus der die Ingots (im Falle von multikristallinem Si) oder Kristalle (im Falle von einkristallinem Si) erzeugt werden. Beim Bridgman-Verfahren werden multikristalline Ingots hergestellt, indem man durch kontrolliertes gerichtetes Erstarren einkristalline Bereiche von bis zu mehreren Zentimetern Durchmesser erzeugt. Beim EFG-Verfahren (Edgedefined Film Growth) wird ein achteckiges "Rohr" aus der Siliciumschmelze gezogen. Das entstandene multikristalline Rohr wird an den Kanten zersägt und zu Wafern verarbeitet. Beim String-Ribbon-Verfahren wird zwischen zwei Drähten ein Band aus der Siliciumschmelze gezogen. Beim RGS-Verfahren (Ribbon Growth on Substrate) entsteht ein Band aus Silicium, indem ein Trägermaterial unter einem Tiegel mit flüssigem Silicium hinbewegt wird. Das Czochralsky-Verfahren ist ein Verfahren zur Herstellung von Silicium-Einkristallen, bei dem ein Kristall aus der Siliciumschmelze gezogen wird. Unter Zieh- und Drehbewegungen scheidet sich an einem Kristallisationskeim ein zylindrisches Silicium-Einkristall ab.

Bei dem erfindungsgemäßen Verfahren wird vorzugsweise ein halogenidhaltiges Silicium eingesetzt, das durch thermische Zersetzung von halogeniertem Polysilan gewonnen wird. Aus der WO 2006/125425 A1 ist ein Verfahren zur Herstellung von Silicium aus Halogensilanen bekannt, bei dem in einem ersten Schritt das Halogensilan unter Erzeugung einer Plasmaentladung zu einem halogenierten Polysilan umgesetzt wird, das nachfolgend in einem zweiten Schritt unter Erhitzen zu Silicium zersetzt wird. Das erfindungsgemäß eingesetzte halogenidhaltige Silicium kann beispielsweise über ein derartiges Verfahren hergestellt werden, wobei das erfindungsgemäß verwendete Silicium vorzugsweise gezielt einen relativ hohen Halogenidgehalt von 1 at%-50 at% aufweisen soll. Dieses Silicium mit relativ hohem Halogenidgehalt wird durch relative niedrige Temperaturen und relativ hohe Drücke bei der thermischen Zersetzung (Pyrolyse) möglich gemacht. Das durch thermische Zersetzung von halogeniertem Polysilan erhaltene Silicium fällt direkt in granulärer Form an.

Das erfindungsgemäß verwendete granuläre halogenidhaltige Silicium wird vorzugsweise so hergestellt, dass das halogenierte Polysilan unter kontinuierlicher Zugabe in einem Reaktor thermisch zersetzt wird. Vorzugsweise wird dabei das halogenierte Polysilan in den Reaktor eingetropft. Durch diese kontinuierliche Vorgehensweise wird der gewünschte relativ hohe Halogenidgehalt erzielt. Die thermische Zersetzung findet dabei vorzugsweise in einem Temperaturbereich von 350 °C-1.200 °C statt, wobei die Temperatur zur Zersetzung des halogenierten Polysilans bevorzugt weniger als 400 °C beträgt. Ferner wird die thermische Zersetzung vorzugsweise bei einem Druck von 10⁻³ mbar bis 300 mbar über Atmosphärendruck durchgeführt, wobei Drücke > 100 mbar bevorzugt werden.

In dem für die thermische Zersetzung verwendeten Reaktor kann eine Inertgasatmosphäre, insbesondere Argonatmosphäre, aufrechterhalten werden.

Die Einstellung des gewünschten Halogenidgehaltes ist durch Variation einer Reihe von Parametern möglich, beispielsweise Einstellen eines gewünschten Zeitprofils, Temperaturprofils und Druckprofils. Wie bereits erwähnt, wird das halogenidhaltige Silicium vorzugsweise direkt in granulärer Form gewonnen. Dies schließt natürlich nicht aus, dass das gewonnene Endprodukt durch weitere mechanische Maßnahmen, wie mechanisches Zerkleinern, Sieben etc., entsprechend modifiziert werden kann, um gewünschte Stoffeigenschaften in bestimmten Bereichen zu erzielen.

Eine weitere Verfahrensvariante zur Einstellung des Halogenidgehaltes des erfindungsgemäß eingesetzten halogenidhaltigen Siliciums betrifft eine Nachbehandlung des erhaltenen Siliciums. Beispielsweise lässt sich der Halogenidgehalt durch Ausheizen reduzieren. So wurde zum Beispiel der Chloridgehalt einer bestimmten Siliciumsorte (Korngröße 50 µm bis 20.000 µm. Chloridgehalt 15 %) durch Ausheizen auf 1.150 °C über vier Stunden bis auf 4 % reduziert. Als geeignete Nachbehandlung seien beispielsweise Ausheizen, Ausheizen unter Vakuum, Zerkleinern oder Sieben erwähnt.

Das erfindungsgemäße Verfahren kann insbesondere zum Entfernen von nichtmetallischen Verunreinigungen aus Vorprodukten von UMG-Silicium verwendet werden. Solche Vorprodukte betreffen beispielsweise UMG-Materialien mit reduziertem Reinigungsaufwand, so dass durch Anwendung des erfindungsgemäßen Verfahrens der Gesamtprozess zur Herstellung von "solar-grade"-Materialien verbilligt wird. Gleichzeitig kann die Qualität der entsprechenden Materialien auf gesteuerte Weise verbessert werden, so dass insgesamt Solarzellen mit höherer Effizienz bei reduzierten Gesamtkosten hergestellt werden können.

### Ausführungsbeispiel

Es wurde ein Gemisch aus 106,8 g UMG-Silicium und 106,5 g granulärem Silicium, erhalten durch thermische Zersetzung von halogeniertem Polysilan, mit einer Korngröße von etwa 800 µm und einem Halogenidgehalt von etwa 30 at% hergestellt. Das erhaltene Gemisch wurde auf einem Aluminiumoxid-Tiegel mit einer Beschichtung aus Si₃N₄ angeordnet und in einem Rohrofen unter einem Druck von 1 at und einer Luft-Atmosphäre mit einem Temperaturgradienten von 4,8 °C/cm Probenvolumen aufgeschmolzen. Die Aufheizphase von 20 °C auf 1.510 °C dauerte 8 h. Die Schmelze wurde 2 h lang auf einer Temperatur von 1.510 °C gehalten. Durch Temperaturabsenkung über 10 h von 1.510 °C auf 1.280 °C erfolgte eine Kristallisation, wonach ein Abkühlvorgang von 1.280 °C auf 20 °C über 12 h folgte.

Aus dem erhaltenen Ingot wurde ein Vertikalschnitt mit einer Dicke von ca. 2 mm angefertigt. Dieser wurde chemisch gereinigt (in HF/HN03) geätzt. Anschließend wurden an dieser Probe GDMS- und ICPMS-Messungen durchgeführt. Dabei konnte gegenüber dem Ausgangsprodukt eine wesentliche Reduzierung des Phosphor- und Bor-Gehaltes festgestellt werden.

Abschließend sei noch bemerkt, dass das in der deutschen Patentanmeldung 10 2008 025 263.8 beschriebene Verfahren und das vorliegende Verfahren zur Entfernung von metallischen und nichtmetallischen Verunreinigungen aus metallurgischem Silicium gemäß der eingangs wiedergegebenen Definition geeignet sind, wobei diese Verfahren eine wesentlich bessere Effizienz besitzen als die Verfahren, bei denen gasförmiges Halogen durch eine Si-Schmelze geblasen wird.

Der hierdurch erzielbare Reinigungseffekt ist wesentlich stärker als bei Verwendung einer gasförmigen Halogenquelle (Chlorquelle). Insgesamt wurden besonders gute Reinigungsergebnisse in Bezug auf die Metalle Na, Mg, Ca, Cr, Fe, Co, Ni, Cu, Mn, Mo, W, Al und Ti und in Bezug auf die Nichtmetalle P und B erzielt. Besonders wertvoll ist der Reinigungseffekt in Bezug auf Mo, W und Ti, die aufgrund ihrer langsamen Diffusion in Si nicht nachträglich, zum Beispiel durch Gettern, entfernt werden können. Das in der deutschen Patentanmeldung 10 2008 025 263.8 beschriebene Verfahren kann ebenfalls insbesondere zum Entfernen von metallischen Verunreinigungen aus Vorprodukten von UMG-Silicium verwendet werden.

Das vorliegende Verfahren ist insbesondere zum Entfernen von nichtmetallischen Verunreinigungen aus metallurgischem Silicium, Vorprodukten von UMG Roh-Silicium oder UMG-Silicium geeignet. Es wird bevorzugt zum Steuern und/oder Einstellen des spezifischen Widerstandes von UMG Roh-Silicium oder von Ingots oder Kristallen aus UMG Roh-Silicium oder Vorprodukten von UMG Roh-Si eingesetzt.

Das metallurgische Silicium (gemäß der eingangs wiedergegebenen Definition), das durch ein vorstehend beschriebenes Verfahren erhalten wird, kann in multikristalliner oder monokristalliner Form vorliegen. Es wird vorzugsweise zur Herstellung von Solarzellen oder Halbleitervorrichtungen verwendet. Erfindungsgemäß lassen sich daher verbesserte Si-Materialien aus Ingots (multikristallines Si) und Kristallen (monokristallines Si) erhalten.

kristallines Si) und Kristallen (monokristallines Si) erhalten.

## Patentansprüche

1. Verfahren zum Entfernen von nichtmetallischen Verunreinigungen aus metallurgischem Silicium mit den folgenden Schritten:
Vermischen von festem halogenidhaltigem Silicium mit dem zu reinigenden metallurgischen Silicium;
Schmelzen der Mischung und dadurch Aussublimieren der Verunreinigungen und Entfernen derselben aus der Schmelze in der Form von Nichtmetallhalogeniden.

2. Verfahren zum Entfernen von nichtmetallischen Verunreinigungen aus metallurgischem Silicium mit den folgenden Schritten:
Aufschmelzen des zu reinigenden metallurgischen Siliciums;
Einführen von festem halogenidhaltigem Silicium in die Schmelze und dadurch Aussublimieren der nichtmetallischen Verunreinigungen und Entfernen derselben aus der Schmelze in der Form von Nichtmetallhalogeniden.

3. Verfahren nach einem der vorangehenden Ansprüche,
**dadurch gekennzeichnet, dass** es zum Entfernen von Dotierungsmitteln eingesetzt wird.

4. Verfahren nach einem der vorangehenden Ansprüche,
**dadurch gekennzeichnet, dass** es zum Entfernen von Bor und/oder Phosphor verwendet wird.

5. Verfahren nach einem der vorangehenden Ansprüche,
**dadurch gekennzeichnet, dass** als halogenidhaltiges Silicium ein solches verwendet wird, das im Gemisch mit Si-Anteilen Halogensilan-Anteile enthält, insbesondere in den Leerräumen von halogenhaltigen Siliciumkörnern Halogensilane (SiₙX₂ₙ₊₂ (X = Halogen)) aufweist.

6. Verfahren nach einem der Ansprüche 1 bis 4, **dadurch gekennzeichnet, dass** als halogenidhaltiges Silicium ein solches verwendet wird, das an Si-Atome chemisch gebundenes Halogen und/oder Chlorid enthält.

7. Verfahren nach einem der vorangehenden Ansprüche,
**dadurch gekennzeichnet, dass** halogenidhaltiges Silicium mit einem Halogenidgehalt von 1 at% bis 50 at% verwendet wird.

8. Verfahren nach einem der vorangehenden Ansprüche,
**dadurch gekennzeichnet, dass** granulares halogenidhaltiges Silicium, insbesondere mit einer Korngröße von 50 µm bis 20.000 µm, verwendet wird.

9. Verfahren nach Anspruch 8, **dadurch gekennzeichnet, dass** halogenidhaltiges Silicium mit einer Schüttdichte von 0,2 g/cm³ bis 1,5 g/cm³ verwendet wird.

10. Verfahren nach einem der vorangehenden Ansprüche,
**dadurch gekennzeichnet, dass** die Schmelze homogenisiert wird.

11. Verfahren nach einem der vorangehenden Ansprüche,
**dadurch gekennzeichnet, dass** es bei Si-Kristallisationsverfahren, beispielsweise bei gerichteter Erstarrung, wie Blockgussverfahren oder Bridgman-Verfahren, Czochralsky-Verfahren, EFG-Verfahren, String-Ribbon-Verfahren, RSG-Verfahren, eingesetzt wird.

12. Verfahren nach einem der vorangehenden Ansprüche,
**dadurch gekennzeichnet, dass** das halogenidhaltige Silicium durch thermische Zersetzung von halogeniertem Polysilan gewonnen wird.

13. Verfahren nach einem der Ansprüche 1 bis 12, **dadurch gekennzeichnet, dass** es zum Entfernen von nichtmetallischen Verunreinigungen aus UMG Roh-Silicium verwendet und/oder zum Steuern und/oder Einstellen des spezifischen Widerstandes von UMG Roh-Silicium, Ingots oder Kristallen aus UMG Roh-Silicium oder von Vorprodukten von UMG Roh-Silicium eingesetzt wird.

## Claims

1. Process for removing nonmetallic impurities from metallurgical silicon, comprising the following steps:
mixing solid halide-containing silicon with the metallurgical silicon to be purified;
melting the mixture and thereby sublimating out the impurities and removing the same from the melt in the form of nonmetal halides.

2. Process for removing nonmetallic impurities from metallurgical silicon, comprising the following steps:
melting the metallurgical silicon to be purified;
introducing solid halide-containing silicon into the melt and thereby sublimating out the nonmetallic impurities and removing the same from the melt in the form of nonmetal halides.

3. Process according to one of the preceding claims, **characterized in that** it is used for removing dopants.

4. Process according to one of the preceding claims, **characterized in that** it is used for removing boron and/or phosphorus.

5. Process according to one of the preceding claims, **characterized in that** the halide-containing silicon used is halide-containing silicon which contains halosilane fractions mixed with Si fractions, in particular comprises halosilanes (SiₙX₂ₙ₊₂ (X = halogen)) in the vacancies of halogen-containing silicon grains.

6. Process according to one of Claims 1 to 4, **characterized in that** the halide-containing silicon used is halide-containing silicon which contains chloride and/or halogen chemically bonded to Si atoms.

7. Process according to one of the preceding claims, **characterized in that** halide-containing silicon having a halide content of 1 at% to 50 at% is used.

8. Process according to one of the preceding claims, **characterized in that** granular halide-containing silicon, in particular having a grain size of 50 *µ*m to 20 000 *µ*m, is used.

9. Process according to Claim 8, **characterized in that** halide-containing silicon having a bulk density of 0.2 g/cm³ to 1.5 g/cm³ is used.

10. Process according to one of the preceding claims, **characterized in that** the melt is homogenized.

11. Process according to one of the preceding claims, **characterized in that** it is used in Si crystallization processes, for example in directional solidification, such as ingot casting processes or Bridgman processes, Czochralsky processes, EFG processes, string ribbon processes, RSG processes.

12. Process according to one of the preceding claims, **characterized in that** the halide-containing silicon is obtained by thermal decomposition of halogenated polysilane.

13. Process according to one of Claims 1 to 12, **characterized in that** it is used for removing nonmetallic impurities from UMG raw silicon and/or for controlling and/or setting the resistivity of UMG raw silicon ingots or crystals of UMG raw silicon or preliminary products of UMG raw silicon.

## Revendications

1. Procédé d'élimination d'impuretés non métalliques de silicium métallurgique comprenant les étapes suivantes :
le mélange de silicium solide contenant des halogénures avec le silicium métallurgique à purifier ;
la fusion du mélange et ainsi la sublimation des impuretés et l'élimination de celles-ci de la masse fondue sous forme d'halogénures de non-métaux.

2. Procédé d'élimination d'impuretés non métalliques de silicium métallurgique comprenant les étapes suivantes :
la fusion du silicium métallurgique à purifier ;
l'introduction de silicium solide contenant des halogénures dans la masse fondue et ainsi la sublimation des impuretés non métalliques et l'élimination de celles-ci de la masse fondue sous forme d'halogénures de non-métaux.

3. Procédé selon l'une quelconque des revendications précédentes, **caractérisé en ce qu'**il est utilisé pour l'élimination d'agents dopants.

4. Procédé selon l'une quelconque des revendications précédentes, **caractérisé en ce qu'**il est utilisé pour l'élimination de bore et/ou de phosphore.

5. Procédé selon l'une quelconque des revendications précédentes, **caractérisé en ce que** le silicium contenant des halogénures utilisé contient en mélange avec des fractions Si des fractions halogénosilane, notamment comprend des halogénosilanes (SiₙX₂ₙ₊₂ (X = halogène)) dans les espaces vides de grains de silicium contenant des halogènes.

6. Procédé selon l'une quelconque des revendications 1 à 4, **caractérisé en ce que** le silicium contenant des halogénures utilisé contient un halogène et/ou un chlorure relié chimiquement aux atomes Si.

7. Procédé selon l'une quelconque des revendications précédentes, **caractérisé en ce qu'**un silicium contenant des halogénures ayant une teneur en halogénures de 1 % at. à 50 % at. est utilisé.

8. Procédé selon l'une quelconque des revendications précédentes, **caractérisé en ce qu'**un silicium contenant des halogénures granulaire, notamment d'une taille de grain de 50 *µ*m à 20 000 *µ*m, est utilisé.

9. Procédé selon la revendication 8, **caractérisé en ce qu'**un silicium contenant des halogénures ayant une densité apparente de 0,2 g/cm³ à 1,5 g/cm³ est utilisé.

10. Procédé selon l'une quelconque des revendications précédentes, **caractérisé en ce que** la masse fondue est homogénéisée.

11. Procédé selon l'une quelconque des revendications précédentes, **caractérisé en ce qu'**il est utilisé dans un procédé de cristallisation de Si, par exemple dans une solidification dirigée, tel que le procédé de coulée en lingotière ou le procédé Bridgman, le procédé Czochralsky, le procédé EFG, le procédé String-Ribbon, le procédé RSG.

12. Procédé selon l'une quelconque des revendications précédentes, **caractérisé en ce que** le silicium contenant des halogénures est obtenu par décomposition thermique de polysilane halogéné.

13. Procédé selon l'une quelconque des revendications 1 à 12, **caractérisé en ce qu'**il est utilisé pour l'élimination d'impuretés non métalliques de silicium brut UMG et/ou pour la régulation et/ou l'ajustement de la résistance spécifique de silicium brut UMG, de lingots ou de cristaux en silicium brut UMG ou de produits préalables de silicium brut UMG.
